# EUROPEAN PATENT SPECIFICATION

(11) **EP 0 386 835 B1**
(45) Date of publication and mention of the grant of the patent: **21.06.1995**
(21) Application number: 90200493.6
(22) Date of filing: 02.03.1990
(51) Int. Cl.: H03J 7/18, G08G 1/09

(54) **Method of processing a radio data signal, and receiver for performing said method**
Verfahren zum Verarbeiten eines Rundfunkdatensignals, sowie Empfänger zum Durchführen dieses Verfahrens
Procédé de traitement d'un signal de données radio et récepteur pour la mise en oeuvre de ce procédé

(30) Priority: 08.03.1989 NL 8900566
(43) Date of publication of application: 12.09.1990
(73) Proprietor: Philips Electronics N.V., 5621 BA Eindhoven (NL)
(72) Inventor: Kamalski, Theodor Ignatius Eduard, NL-5656 AA Eindhoven (NL)
(74) Representative: Schoonheijm, Harry Barend

(56) References cited:
- EP-A- 0 305 172
- DE-U- 8 717 290
- ELECTRONICS & WIRELESS WORLD, vol. 93,no. 1620, October 1987, pages 1023-1026, Sutton, Surrey, GB; S. SHUTE: "Towards the intelligent radio"

## Description

The invention relates to an FM radio receiver for receiving a digital radio data signal included in an FM radio broadcasting signal, said receiver comprising an FM receiver section for tuning to a desired FM radio broadcasting signal and for processing the digital radio data signal into digital information relating to at least first and second programs having first and second program identification codes and to alternative frequencies grouped in accordance with said first and second program identification codes, one of the two programs comprising traffic information, a control circuit and a memory circuit comprising at least first and second arrays of memory sites for storing the alternative frequencies grouped in accordance with the first and second program identification codes in first and second frequency lists, respectively, said control circuit controlling an automatic change-over of the tuning from an alternative frequency of the one program to which frequency the receiver was actually tuned to an alternative frequency of the other program if the other program broadcasts traffic information.

Such an FM radio receiver is known from the EBU technical document 3244E of March 1984, entitled "Specifications of the radio data system RDS for VHF/FM sound broadcasting". When tuned to a program without traffic information, the known FM receiver provides the possibility of automatically changing over from, for example the said first program to a program with traffic information, i.e. the second program in this example, at the time when this traffic information is broadcast. The creation of frequency pairs is known from DE-A-8 717 290, where it is used for transmitting alternative frequencies, all belonging to one program. The creation of two frequency lists is known from EP-A-0 305 172, where one list is used for alternative frequencies corresponding to the stored PI code and the other list for alternative services, identified by PI codes, which are partly corresponding with the PI code of the actual received program.

To this end the PI code of this second program, briefly referred to as second PI code, together with a list of alternative frequencies (AFs) at which the second program can be received is transmitted by means of a so-called Other Network (ON) or type 3 group code word - hereinafter shortly referred to as on group - in the RDS signal of the first program. If traffic information is broadcast, a so-called TA (traffic announcement) code is transmitted along with the RDS signal of the first program in the ON group. When receiving such a TA code, the AF having the best signal reception quality is searched in the AF list of the second program, which is followed by tuning to this AF. Since it may happen in practice, for example in the neighbourhood of national borders or, for example in regions with many pirate stations, that a transmitter which is not associated with the network of the second program is received at the last-mentioned AF, it is first checked whether the PI code of the program received at this AF corresponds to the second PI code. In practice it is particularly this PI check which is rather time-consuming so that it fairly often occurs in the known FM receiver that a considerable part of the desired traffic information is missed.

Recently an improved version of the ON group was defined, the so-called Enhanced Other Network (EON) or type 14 group. A further description of this group is given in Supplement 4 of the above-mentioned EBU document. The EON group has an A and a B version, the A version being intended for the successive transmission of so-called EON data and the B version being intended to indicate the start or the end of a traffic message in the exemplary second program by means of a rapid repetition frequency. Although the reliability of transmitting EON data is improved with this EON group as compared with the prior ON group, a PI check remains necessary when changing over the tuning from the first to the second program so that the use of the EON group prescribed in the said Supplement also fairly often leads to a considerable part of a traffic message being missed at the start.

It is an object of the invention to provide a very rapid and reliable change-over of a program without traffic information to a program with traffic information.

According to the invention an FM receiver of the type described in the opening paragraph is characterized in that the control circuit comprises means for forming a plurality of frequency pairs, the first frequency in the pair being selected from a plurality of alternative frequencies in the first frequency list and the second frequency in the pair being selected from a plurality of alternative frequencies in the second frequency list, while for each frequency pair the transmitters to which the two alternative frequencies relate have a substantially mutually equal transmitter location and transmitter range, means for changing over the tuning from the one frequency of said frequency pair to the other frequency of the frequency pair if traffic information is transmitted at the last-mentioned other frequency.

The invention is based on the recognition that transmitters with different programs which are located in one transmitter installation or are located comparatively close to each other have transmitter frequencies in practice which deviate from those of other transmitters which can be received in the transmission range of these transmitters.

When using the measure according to the invention this recognition is utilized by switching over to that AF in the AF list of the program with traffic information which substantially corresponds to the AF of the actual transmitter in the reception range. The risk that an unwanted program is received at this AF is substantially excluded. Since this so-called mapped relationship between AFs relating to transmitters having a substantially mutually equal transmission range hardly changes, this relationship can be manually introduced by the user, if he has foreknowledge of it, or it can be read from a ROM.

In a preferred embodiment the formation of such mapped frequency pairs is automated by using relevant EON data in the EON group. Such a preferred embodiment is characterized by a code word detector for detecting a code word incorporated in the radio data signal and preceding two alternative frequencies which jointly form a frequency pair.

The invention will be described in greater detail by way of example with reference to the accompanying drawings in which
Fig. 1 shows the defined EON group code word;
Fig. 2 shows an FM receiver according to the invention.

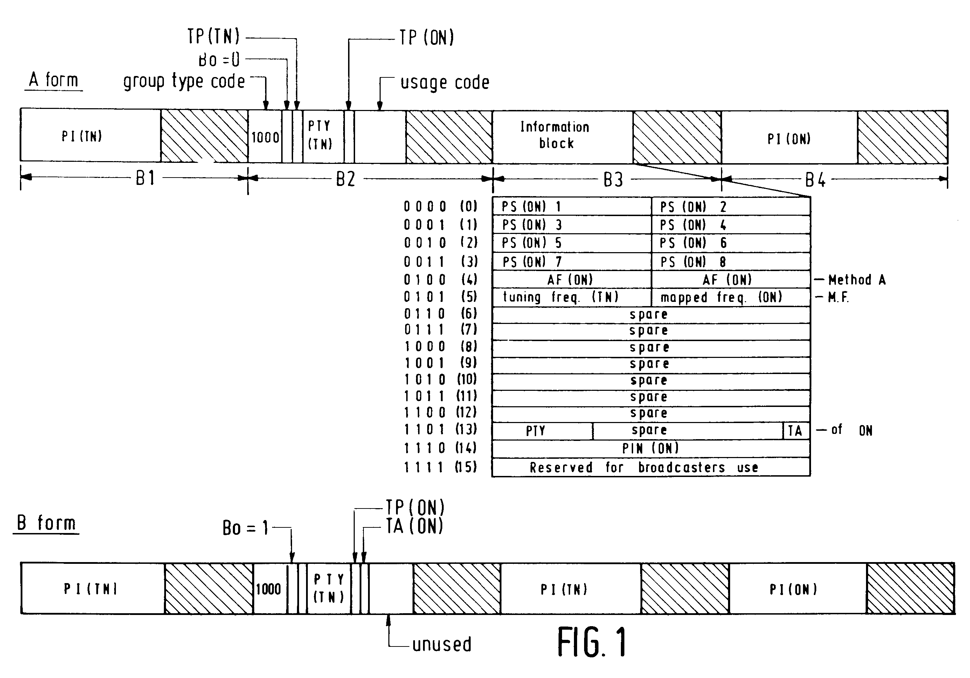

Fig. 1 shows versions A and B of a recently defined group code word which can be transmitted in a digital signal (RDS) of an FM radio broadcasting signal, or the so-called type 14 group, also referred to as the EON (enhanced other network) group or EON code word. Version B of the EON group is transmitted at a comparatively rapid repetition frequency at the start and the end of a traffic message in the program with the PI code incorporated in the fourth block.

Version A of the EON code word is intended to transmit and update information relating to the AF, PTY, PS, TP, TA and PIN code of programs other than the actual program, i.e. other than the program of the transmitter to which the receiver is tuned. In this function the EON code word corresponds to the previously defined ON (other network) or type 3 group code word. However, the transmission of the above-mentioned information by means of the EON code word is much less sensitive to interference than the transmission by means of the ON code word because, unlike the ON code word, the PI code of the program to which the said information relates is repeated in each transmitted EON code word.

The A version of the EON code word comprises first to fourth subsequent blocks each having 16 information bits. The first block B1 gives the PI code of the actual program PI(TN), the second block B2 gives a group type code (group type 14), a version code B0 (version A), a traffic information or program type code relating to the actual program TP(IN) and PTY(IN), a traffic information code of another program TP(ON), and a 4-bit usage code (UC).

The UC refers to the information in the third block B3 in the manner shown in the Figure. The bit series 0101 for the UC indicates that two frequencies are incorporated in this third block B3, the first frequency being a frequency with a program signal corresponding to the program signal of the actual transmitter - hereinafter referred to as an AF associated with the actual tuned network TN. The second frequency is the frequency of a transmitter with a program signal whose PI code is indicated as PI(ON) in the fourth block B4 and which deviates from that of the actual transmitter. This second frequency is hereinafter referred to as an AF associated with another network ON. The transmitter location and transmitter range of the transmitters to which the first and second frequencies relate mutually substantially correspond. These two frequencies thus overlap each other with regard to their transmitter range and are therefore referred to as overlapping, or mapped frequencies (MFs). For a further description of the significance of these codes reference is made to the above-mentioned EBU document.

In a subsequent EON code word another AF in the list of the actual transmitter, i.e. the TN AF list, can be paired with an AF in the frequency list of the said other network, i.e. the ON AF list. This may be repeated for the AFs in the AF list of yet another network. In this way there may not only be a mapped relationship between the AFs of two frequency lists, but also between the AFs of three or more frequency lists. The AFs associated with a frequency set (i.e. frequency pair, trio, quartet, etc.) mutually have the above-mentioned mapped relationship. If traffic information is transmitted in several programs, and when receiving the B version of the EON group, there will be a change-over to an AF with the PI(ON) code as occurs in the fourth block B4 which forms a mapped frequency pair with the actual tuning frequency if there is a mapped relationship between the AFs at which these programs can be received.

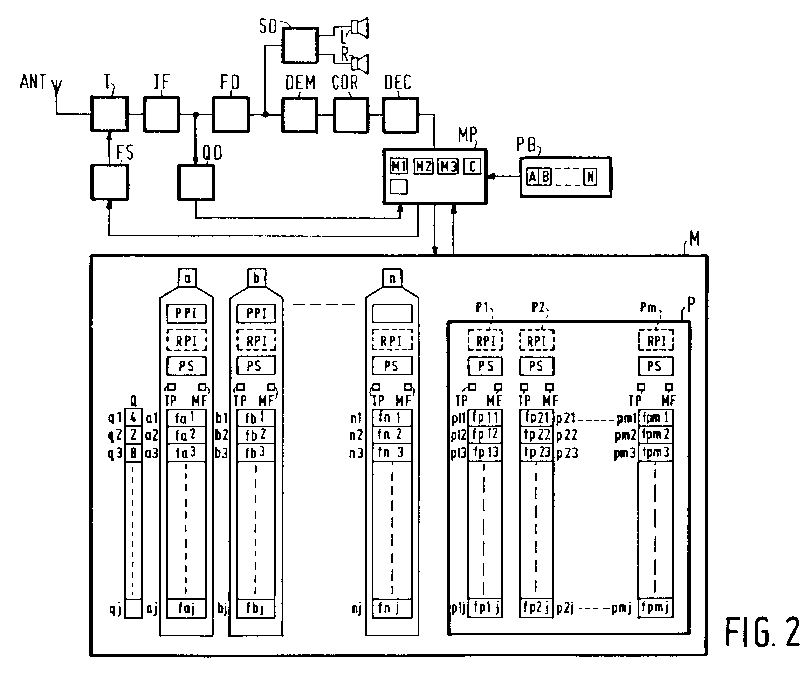

Fig. 2 shows an FM receiver according to the invention having an FM receiver section comprising a tuning section T to which an intermediate frequency section IF, a frequency detector FD, an RDS demodulator, an error correction and block-synchronizing circuit COR and an RDS decoder DEC are successively coupled. RF FM broadcasting signals are applied from an antenna device ANT to the FM receiver section in which tuning to a desired FM RF broadcasting signal is effected and in which a modulated digital RDS signal possibly included therein is processed into digital RDS information.

An output of the frequency detector FD is coupled to a stereo decoder and audio signal processing unit SD, which supplies left and right stereo signals to left and right stereo loudspeakers L and R.

The RDS decoder DEC supplies digital RDS information to a control circuit MP which is coupled to a memory circuit M and which the user can give tuning commands from an operating panel PB. The operating panel PB has a number of tuning keys A-N by means of which the user can activate memory banks a-n of the (preset) memory circuit M via the control circuit MP. Each of these memory banks a-n has memory sites PPI, RPI, PS, TP, MF as well as a number of arrays of memory sites (1-j) in which it is possible to store a preset PI code, the actual PI code or the PI code of the actual program, the program service (PS) name of the actual program, a flag for indicating a traffic message (TP), a flag for indicating a mapped relationship between the AFs of the relevant AF list with that of the actual transmitter frequency as well as a frequency list for the storage of a maximum number of j frequencies of transmitters having the same program as the actual transmitters, briefly referred to as AF list.

The memory circuit M also comprises a working memory P with so-called pool stores 1-m, which cannot be directly activated by the user. With the exception of the memory site PPI, each of these pool stores 1-m has memory sites corresponding to the memory sites RPI, PS, TP, MP as well as an array of memory sites (1-j) of the memory banks a-n. They are used for storing data of programs having a given relationship with the programs stored in the memory banks a-n or certain messages which are often desired, such as, for example traffic messages. The storage of program data in the working memory P is realised by the control circuit MP which automatically allocates, inter alia programs with a PI code, the last two hexadecimal characters of which correspond to the PI code of the programs allocated to the memory banks a-n, to a number of the pool stores p1-pm in which the PI code, PS name, TP and MF information and an AF list are stored. Also programs which are coupled via the EON code word to a program which is allocated to one of the memory banks a-n and/or programs with traffic information can be automatically allocated to a number of pool stores p1-pm. The processing steps required for this purpose can be realised by means of a suitable program in the control circuit MP.

The user can allocate preset programs to each tuning key A-N in known manner by storing the PI codes of these preset programs at memory sites PPI of the memory banks a-n. When selecting an FM-RDS broadcasting signal with a given PI code, tuning will be effected at, for example fa1 if the PI code of the desired program corresponds to that of the memory bank a. fa1, Being the actual frequency is stored at the memory site a1 of a. Via the so-called type OA group the AF list of this memory bank a is further filled with the AFs fa2-faj associated with the actual transmitter frequency fa1 and the reception quality of the RF-FM broadcasting signal at each of these AFs including fa1 is measured in known manner, stored in a memory Q with memory sites q1-qj which correspond to memory sites a1-aj, respectively, and updated continuously. To this end the control circuit MP tunes the tuning section T via a frequency synthesis circuit FS to each of the AFs for a short period of time and the reception quality detector QD measures the reception quality, for example by way of the field strength and/or multipath reception of the RF-FM broadcasting signal of the relevant AF. If the signal reception quality at, for example fa3 is better than at the afore-mentioned fa1, the tuning is changed over from fa1 to fa3.

When receiving an EON code word, the presence of the said bit series 0101 in the UC in the second block is detected in a code word detector in the control circuit MP. If this bit series occurs, two AFs of a frequency pair follow in the third block B3, the first AF referring to the actual network (TN) and the second referring to the so-called other network (ON) whose PI code is mentioned in the fourth block B4. When detecting the said bit series in the UC in the second block B2, the said second frequency (ON) in the third block B3 of the EON code word is stored in the memory bank with the PI code of the other network PI-(ON) at a memory site which corresponds to the memory site of the first frequency (TN) in the AF list of the actual transmitter frequency mentioned in the third block B3. If the said PI code of the other network PI(ON) is allocated to none of the memory banks a-n, the control circuit MP allocates this PI code PI (ON) to one of the pool stores p1-pm of the working memory (pool store) P.

For example, the frequencies fax and fkx mentioned as a mapped frequency pair in the third block B3 will be stored in the arrays of memory sites a and k, respectively, at mutually corresponding memory sites x, with a being, for example a preset memory bank and k being a preset memory bank or a pool store. In this way the AF lists of the pool stores a and k are filled with frequencies of mapped frequency pairs (MF pairs) at corresponding memory sites. Both frequencies of such a frequency pair relate to mutually substantially equal transmitter locations and to a transmitter power or transmitter range which is known beforehand and which is equal in most cases.

In practice it may occur that more than two transmitters, for example three, four or n transmitters transmit mutually different programs in a mutually substantially identical transmitter range. This so-called mapped relationship can be transferred in the manner described above via a number of EON words and can be used to store these frequencies at corresponding memory sites in the relevant three, four or n number of arrays of memory sites (memory banks or pool stores), thus forming a mapped frequency trio, quartet or generally a frequency set, for example the frequency trio fax, fbx, fcx; the frequency quartet fax, fbx, fcx, fdx or the frequency set fax, ..., fnx. The same method of storage at mutually corresponding memory sites is used for the other AFs in the AF lists of said memory banks or pool stores which jointly form a frequency set.

The non-active array of memory sites whose AFs form a frequency set with the AFs of the active one, in the given case, for example the memory bank a, are provided with a mapped frequency indication bit at the memory site MF of each of these non-active arrays of memory sites.

If the receiver is tuned to a program without traffic information, for example to fa3 of the memory bank a with PI code PI(TN) and the PI code of a program with traffic information, for example PI(ON) and if it is stored in, for example the pool store p2 of the working memory P together with the associated AF list, and if there is a mapped relationship between the AFs of PI(ON) and the AFs of PI(TN), there will be a change-over of the tuning to that AF in the AF list of PI(ON) having a mapped relationship with fa3 when receiving a rapidly repeating version B of EON groups. By storing mapped frequencies at corresponding memory sites in the relevant AF lists a rapid recognition of the frequency or frequencies having a mapped relationship with the actual frequency is possible. In the afore-mentioned example a change-over will then take place from fa3 to fp23.

If there is no frequency in the AF list of PI(ON) which forms a mapped frequency pair with fa3, that AF in the AF list of PI(ON) can be searched which forms a mapped frequency pair with the AF in the AF list of PI(TN) coming after the actual transmitter frequency fa3 as far as reception quality is concerned.

It will not be difficult to those skilled in the art to realise these operations by means of suitable programs in the control circuit MP and/or the RDS decoder DEC.

## Claims

1. An FM receiver for receiving a digital radio data signal included in an FM radio broadcasting signal, said receiver comprising an FM receiver section for tuning to a desired FM radio broadcasting signal and for processing the digital radio data signal to digital information relating to at least first and second programs having first and second program identification codes and to alternative frequencies grouped in accordance with said first and second program identification codes, one of the two programs comprising traffic information, a control circuit (mp) and a memory circuit (m) comprising at least first and second arrays of memory sites for storing the alternative frequencies grouped in accordance with the first and second program identification codes in first and second frequency lists, respectively, and an automatic change-over, controlled by the control circuit (mp), of the tuning from an alternative frequency of the one program to which frequency the receiver was actually tuned to an alternative frequency of the other program if the other program broadcasts traffic information, characterized in that the control circuit (mp) comprises means for forming a plurality of frequency pairs, the first frequency in the pair being selected from a plurality of alternative frequencies in the first frequency list and the second frequency in the pair being selected from a plurality of alternative frequencies in the second frequency list, while for each frequency pair the transmitters to which the two alternative frequencies relate have a substantially mutually equal transmitter location and transmitter range, means for changing over the tuning from the one frequency of said frequency pair to the other frequency of the frequency pair if traffic information is transmitted at the last-mentioned other frequency.

2. An FM receiver as claimed in Claim 1, characterized by a code word detector for detecting a code word included in the radio data signal and preceding two alternative frequencies which jointly form a frequency pair.

3. An FM receiver as claimed in Claim 2, characterized in that the control circuit (mp) stores the said pair of alternative frequencies at mutually corresponding memory sites in the first and second frequency lists.

## Patentansprüche

1. FM-Rundfunkempfänger zum Empfang eines digitalen Rundfunkdatensignals, das in ein Rundfunksignal aufgenommen ist, mit einem FM-Empfängerteil zur Abstimmung auf ein gewünschtes FM-Rundfunksignal und zur Verarbeitung des digitalen Rundfunkdatensignals zu digitaler Information in bezug auf wenigstens ein erstes und ein zweites Programm mit einem ersten bzw. zweiten Programmkenncode und in bezug auf diesen ersten und zweiten Programmkenncoden zugeordnete alternative Frequenzen, wobei eines der beiden Programme Verkehrsnachrichten aufweist, eine Steuerschaltung (MP) und eine Speicherschaltung (M) mit wenigstens einer ersten und einer zweiten Speicherbank zur Speicherung in ersten bzw. zweiten Frequenzlisten der nach den ersten und zweiten Programmkenncoden gegliederten alternativen Frequenzen, wobei die genannte Steuerschaltung (MP) einen automatischen Übergang der Abstimmung von einer alternativen Frequenz des einen Programms, auf die der Empfänger bereits abgestimmt war, auf eine alternative Frequenz des anderen Programms steuert, wenn das andere Programm Verkehrsinformation sendet, dadurch gekennzeichnet, daß die Steuerschaltung (MP) mit Mitteln versehen ist zum Bilden einer Anzahl alternativer Frequenzen in der ersten Frequenzliste zusammen mit einer Anzahl alternativen Frequenzen in der zweiten Frequenzliste zu einer Anzahl Frequenzpaare, wobei für jedes Frequenzpaar die Sender, auf die sich die beiden alternativen Frequenzen beziehen, eine im wesentlichen untereinander gleiche Senderstelle und gleichen Sendebereich haben, mit Mitteln zum Umschalten von der Abstimmung der einen Frequenz dieses Frequenzpaares auf die andere Frequenz des Frequenzpaares falls Verkehrsnachrichten auf der letztgenannten anderen Frequenz übertragen werden.

2. FM-Empfänger nach Anspruch 1, dadurch gekennzeichnet, daß ein Codewortdetektor vorgesehen ist, zur Detektion eines in dem Funkdatensignal vorhandenen Codewortes vor jedem Paar alternativer Frequenzen, die zusammen ein Frequenzpaar bilden.

3. FM-Empfänger nach Anspruch 2, dadurch gekennzeichnet, daß die Steuerschaltung (MP) das genannte Paar alternativer Frequenzen an einander entsprechenden Speicherstellen in der ersten und zweiten Liste speichert.

## Revendications

1. Récepteur radio FM destiné à recevoir un signal de données radionumériques inclus dans un signal de radiodiffusion FM, ledit récepteur comprenant une section réceptrice FM destinée à s'accorder sur un signal de radiodiffusion FM souhaité et à traiter le signal de données radionumériques en informations numériques se rapportant à au moins un premier et un deuxième programmes ayant un premier et un deuxième codes d'identification de programmes et à des fréquences alternatives groupées conforméments auxdits codes d'identification du premier et du deuxième programmes, un des deux programmes comprenant des informations de trafic, un circuit de commande (MP) et un circuit de mémoire (M) comprenant au moins un premier et un deuxième réseaux de sites de mémoire pour stocker les fréquences alternatives groupées conformément aux codes d'identification du premier et du deuxième programmes dans une première et une deuxième listes de fréquences, respectivement, et une commutation automatique, commandée par ledit circuit de commande (MP), de l'accord d'une fréquence alternative du premier programme sur laquelle le récepteur était présentement accordé à une fréquence alternative de l'autre programme si l'autre programme diffuse des informations de trafic, caractérisé en ce que le circuit de commande (MP) comprend des moyens pour former un pluralité de paires de fréquences, la première fréquence de la paire étant sélectionnée parmi une pluralité de fréquences alternatives de la première liste de fréquences et la deuxième fréquence de la paire étant sélectionnée parmi une pluralité de fréquences alternatives de la deuxième liste de fréquences, tandis que, pour chaque paire de fréquences, les émetteurs auxquels les deux fréquences alternatives se rapportent ont des emplacements d'émetteurs et des portées d'émission sensiblement et mutuellement égaux, des moyens pour passer de la première fréquence de ladite paire de fréquences à l'autre fréquence de ladite paire de fréquences si des informations de trafic sont transmises à l'autre fréquence mentionnée en dernier lieu.

2. Récepteur FM selon la revendication 1, caractérisé par un détecteur de mot de code pour détecter un mot de code inclus dans le signal de données radio et précédant deux fréquences alternatives qui forment conjointement une paire de fréquences.

3. Récepteur FM selon la revendication 2, caractérisé en ce que le circuit de commande (MP) stocke ladite paire de fréquences alternatives dans des sites de mémoire mutuellement correspondants dans la première et la deuxième listes de fréquences.
